(19)

Europäisches Patentamt

European Patent Office

Office européen des brevets

(11) **EP 4 475 356 A1**

(12) **EUROPEAN PATENT APPLICATION**
published in accordance with Art. 153(4) EPC

(43) Date of publication:
**11.12.2024 Bulletin 2024/50**

(21) Application number: **23749476.0**

(22) Date of filing: **10.01.2023**

(51) International Patent Classification (IPC):
**H01S 1/06** $^{(2006.01)}$      **G04F 5/14** $^{(2006.01)}$

(52) Cooperative Patent Classification (CPC):
**G04F 5/14; H01S 1/06**

(86) International application number:
**PCT/JP2023/000305**

(87) International publication number:
**WO 2023/149159 (10.08.2023 Gazette 2023/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **01.02.2022   JP 2022014486**

(71) Applicants:
• **RIKEN**
  **Wako-shi, Saitama 351-0198 (JP)**
• **JEOL Ltd.**
  **Akishima-shi, Tokyo 196-8558 (JP)**

(72) Inventors:
• **KATORI, Hidetoshi**
  **Wako-shi, Saitama 351-0198 (JP)**
• **YANG, Hiu Tat Antony**
  **Wako-shi, Saitama 351-0198 (JP)**
• **TAKAMOTO, Masao**
  **Wako-shi, Saitama 351-0198 (JP)**
• **TSUJI, Shigenori**
  **Akishima-shi, Tokyo 196-8558 (JP)**

(74) Representative: **Boult Wade Tennant LLP**
**Salisbury Square House**
**8 Salisbury Square**
**London EC4Y 8AP (GB)**

(54) **MAGNETO-OPTICAL TRAP DEVICE, PHYSICAL PACKAGE, PHYSICAL PACKAGE FOR OPTICAL GRID CLOCK, PHYSICAL PACKAGE FOR ATOMIC CLOCK, PHYSICAL PACKAGE FOR ATOMIC INTERFEROMETER, PHYSICAL PACKAGE FOR QUANTUM INFORMATION PROCESSING DEVICE, AND PHYSICAL PACKAGE SYSTEM**

(57)     In this magneto-optical trap device, five laser beams are irradiated in a trap space in which atoms are trapped. Of the five laser beams, three laser beams (laser beams $a_1$, $a_2$, $a_3$) pass through the inside of the same plane (Z plane) and are irradiated in the trap space. The two laser beams that intersect that plane (laser beams $a_4$, $a_5$) are irradiated in the trap space. The laser beam $a_1$ is used together as a slowing laser beam b for Zeeman slower.

FIG. 2A

EP 4 475 356 A1

Processed by Luminess, 75001 PARIS (FR)

**Description**

TECHNICAL FIELD

The present disclosure relates to a magneto-optical trap apparatus, a physics package, a physics package for an optical lattice clock, a physics package for an atomic clock, a physics package for an atomic interferometer, a physics package for a quantum information processing device, and a physics package system.

BACKGROUND

An optical lattice clock is an atomic clock which was proposed in the year 2001 by Hidetoshi Katori, one of the inventors of the present disclosure. In the optical lattice clock, an atomic cloud is entrapped within an optical lattice formed by a laser beam, and a resonance frequency of a visible light region is measured. Because of this, the optical lattice clock enables measurement with a precision of 18 digits, far exceeding precision of cesium clocks which are presently available. The optical lattice clocks are now eagerly being researched and developed by the group of the present inventors, and also by various groups in and out of Japan, and are now emerging as next-generation atomic clocks.

As recent techniques for the optical lattice clock, for example, Patent Documents 1 to 3 described below may be exemplified. Patent Document 1 describes that a one-dimensional moving optical lattice is formed inside an optical waveguide having a hollow passageway. Patent Document 2 describes a configuration in which an effective magic frequency is set. In fact, a magic wavelength is theoretically and experimentally determined for strontium, ytterbium, mercury, cadmium, magnesium, and the like. Patent Document 3 describes a radiation shield which reduces influences from black body radiation emanating from the walls at the periphery.

In the optical lattice clock, in order to perform time measurement with high precision, an altitude difference of 1 cm on the earth based on a general relativity effect due to the force of gravity can be detected as a deviation of progression of time. Thus, if the optical lattice clock can be made smaller and portable so that the optical lattice clock may be used in fields outside of a research laboratory, application possibilities can be widened for new geodetic techniques such as search for underground resources, underground openings, detection of magma reservoirs, and the like. By producing the optical lattice clocks on a massive scale and placing them in various places to continuously monitor a variation in time of the gravity potential, applications may be enabled, such as detection of crustal movement and spatial mapping of a gravity field. In this manner, optical lattice clocks are expected to contribute to society as a new fundamental technology, beyond a frame of highly precise time measurement.

The first stage of a typical physics package for an optical lattice clock consists of an atomic beam oven and a Zeeman slower. A cool atomic beam is generated at the first stage. The generated cool atomic beam is output to a magneto-optical trap apparatus (MOT apparatus), which is in the second stage.

In general, the Zeeman slower includes a bore, and a magnetic field generator that generates a magnetic field along a center axis of the bore. The Zeeman slower decelerates, through Zeeman deceleration, an atomic beam emitted from the atomic oven and having a high initial velocity to a velocity at which the beam can be trapped by the magneto-optical trap apparatus in the second stage. A laser beam is illuminated from an opening of the bore into the bore. The laser beam is a laser beam which propagates in a direction opposite the direction of propagation of the atomic beam, and which has a frequency obtained by correcting a Doppler shift term from an atomic transition resonance frequency. With a strong radiation force of the laser beam, the atomic beam is decelerated. Further, by forming, with the magnetic field generator, a magnetic field with a spatial gradient centered at the bore, a change of the Doppler shift due to the deceleration can be compensated for with the Zeeman shift, so as to achieve a situation in which the laser beam for deceleration always resonates with respect to the atom.

The magneto-optical trap apparatus positioned in the second stage traps the atoms with a plurality of laser beams and a quadrupole magnetic field formed with a center at the position where the atoms are trapped.

The frequency of the laser beam is set to a value detuned to a negative side from the resonance frequency of the atoms. When photons of the laser beam are absorbed by the atoms, momentum of the photon is supplied to the atom, and acts as a radiation pressure with respect to the atom. When the atom moves with a finite velocity, Doppler shift occurs in a frequency of a laser beam opposing the motion, so that the frequency becomes closer to the resonance frequency of the atom. On the other hand, Doppler shift occurs in a frequency of a laser beam parallel to the direction of the motion, so that the frequency is deviated from the resonance frequency of the atom. Therefore, the atom more strongly receives the radiation pressure from the laser beam opposing the motion, and, as a result, the atoms decelerate.

Further, a radiation pressure having position dependency can be generated by the quadrupole magnetic field. More specifically, the radiation pressure with the position dependency is a radiation pressure which causes a larger Zeeman shift in the resonance frequency of the atom with increasing distance from the center of a trap space. Further, by selecting the polarization of the laser beam, it is possible to direct the direction of application of the radiation pressure to a direction toward the center.

As described, by combining the Zeeman slower and the magneto-optical trap apparatus, atomic beam with high velocity can be decelerated, and the atoms can be trapped in the trap space.

For example, when the strontium atoms are used as an atomic source, a laser beam having a wavelength of 461 nm is used as the laser beam for deceleration.

CITATION LIST

PATENT LITERATURE

Patent Document 1: JP 6206973 B
Patent Document 2: JP 6635608 B
Patent Document 3: JP 7189588 B

SUMMARY

TECHNICAL PROBLEM

The Zeeman deceleration and the magneto-optical trapping are generally performed under ultra-high vacuum. Downsizing and weight reduction of the apparatus is considered. A configuration with fewer components and an easy to install arrangement is desirable. When optical elements are installed in a vacuum chamber, the number of vacuum-resistant optical windows in the vacuum wall should be reduced. In optical paths where optical elements are all placed in the vacuum chamber, the vacuum chamber becomes larger, so it is preferable to place the minimum number of necessary components in the vacuum chamber and the rest on the atmospheric side. In addition, arranging components in a row or on a flat surface takes up less space, but arranging multiple components in a three-dimensional manner increases the number of element mounts and increases the size of the apparatus.

In the following, for the purpose of realizing reduction of the size of the apparatus, a structure for realizing "a plurality of laser beams" used in the magneto-optical trap will be considered.

A direction of propagation of a laser beam realizing the magneto-optical trap is defined as:

$$\vec{a}_j$$

Here, "j" is an index of each element (each laser). It is presumed that the laser beams have equal intensities.

In order to decelerate atoms which move three-dimensionally, a condition represented by the following Equation (1) must be satisfied.

[Equation 1]

$$\sum_j \vec{a}_j = 0$$

A direction of propagation of the laser beam in the Zeeman slower is defined as:
$$\vec{b}$$
The vector "b" is antiparallel with an axis of the atomic beam.

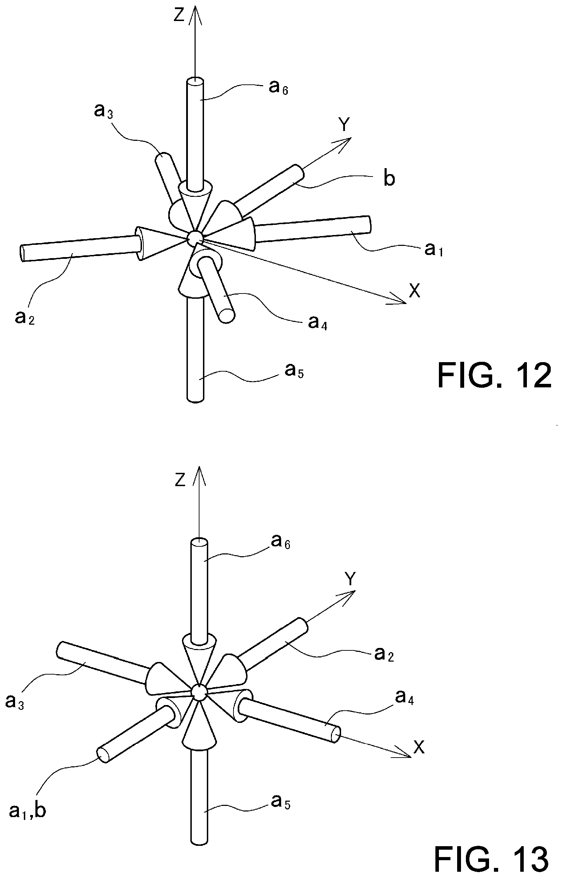

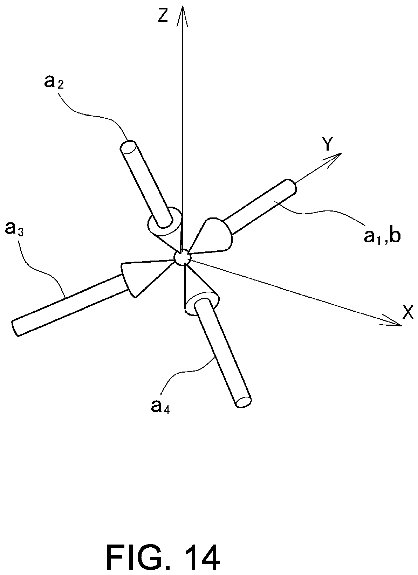

FIG. 12 shows a plurality of laser beams according to Related Art (1). FIG. 12 shows a Cartesian coordinate system (X axis, Y axis, and Z axis which are orthogonal to each other). This is similarly applicable to FIGs. 13 and 14.

In Related Art (1), six laser beams (laser beams $a_1$, $a_2$, $a_3$, $a_4$, $a_5$, $a_6$) are used as laser beams for the magneto-optical trap, and one laser beam (laser beam b) is used as a laser beam for Zeeman deceleration. The laser beams $a_1$ and $a_2$ propagate in directions opposite from each other, the laser beams $a_3$ and $a_4$ propagate in directions opposite from each other, and the laser beams $a_5$ and $a_6$ propagate in directions opposite from each other. The directions of propagation for the laser beams $a_1$, $a_2$, $a_3$, $a_4$, $a_5$, $a_6$, and b are defined by the following Equation (2).

[Equation (2)]

$$\vec{a_1} = (-\vec{x} - \vec{y})/\sqrt{2},$$

$$\vec{a_2} = (\vec{x} + \vec{y})/\sqrt{2},$$

$$\vec{a_3} = (\vec{x} - \vec{y})/\sqrt{2},$$

$$\vec{a_4} = (-\vec{x} + \vec{y})/\sqrt{2},$$

$$\vec{a_5} = \vec{z},$$

$$\vec{a_6} = -\vec{z},$$

$$\vec{b} = -\vec{y}.$$

Here,

$$\left[\vec{x}, \vec{y}, \vec{z}\right]$$

represents a unit vector in the Cartesian coordinate system.

FIG. 13 shows a plurality of laser beams in Related Art (2). In Related Art (2), six laser beams (laser beams $a_1$, $a_2$, $a_3$, $a_4$, $a_5$, $a_6$) are used as the laser beams for the magneto-optical trap, and one of these laser beams (also called laser beam b) is used also as the laser beam for Zeeman deceleration. The directions of propagation of the laser beams $a_1$, $a_2$, $a_3$, $a_4$, $a_5$, $a_6$, and b are defined by the following Equation (3).

[Equation (3)]

$$\vec{a_1} = \vec{y},$$

$$\vec{a_2} = -\vec{y},$$

$$\vec{a_3} = \vec{x},$$

$$\vec{a_4} = -\vec{x}.$$

$$\vec{a_5} = \vec{z},$$

$$\vec{a_6} = -\vec{z},$$

$$\vec{b} = \vec{y}.$$

FIG. 14 shows a plurality of laser beams in Related Art (3). In Related Art (3), four laser beams (laser beams $a_1$, $a_2$, $a_3$, $a_4$) are used as the laser beams for the magneto-optical trap, and one of these laser beams (also called laser beam b) is used also as the laser beam for Zeeman deceleration. The directions of propagation of the laser beams $a_1$, $a_2$, $a_3$, $a_4$, and b are defined by the following Equation (4).

[Equation (4)]

$$\vec{a_1} = -\vec{y},$$

$$\vec{a_2} = \frac{1}{3}\vec{y} - \frac{2\sqrt{2}}{3}\vec{z},$$

$$\vec{a_3} = \sqrt{\frac{2}{3}}\vec{x} + \frac{1}{3}\vec{y} + \frac{\sqrt{2}}{3}\vec{z},$$

$$\vec{a_4} = -\sqrt{\frac{2}{3}}\vec{x} + \frac{1}{3}\vec{y} + \frac{\sqrt{2}}{3}\vec{z},$$

$$\vec{b} = -\vec{y}.$$

The structure of Related Art (3) is considered to be the minimum structure which satisfies Equation (1) (Optics Letters 16 (1991) 339, F. Shimizu et al.). As an example structure realizing the four laser beams, there may be exemplified a structure which generates a set $\{a_2, a_3, a_4\}$ with three mirrors (Optics Express 17 (2009) 13601, M. Vangeleyn et al.), and a structure which generates a set $\{a_2, a_3, a_4\}$ with an equilateral triangular grating (US Patent No. 11291103).

In Related Art (1), the seven laser beams are generated, for example, with three mirrors. Specifically, the laser beams $a_2$, $a_4$, and $a_6$ are generated respectively from the laser beams $a_1$, $a_3$, and $a_5$. The laser beam as and the laser beam as are generated from the laser beam $a_1$ using a mirror. In this manner, it is not necessary to separately prepare the seven laser beams, but there is a problem in that the number of optical elements such as the mirrors is increased.

In Related Art (2), the laser beams $a_1$ and b are realized with one laser beam. Therefore, the structure may be thought to be simplified in comparison to Related Art (1). However, in order to illuminate the laser beam $a_2$, in the actual equipment, a complicated devisal is necessary in order to prevent interference of the laser beam $a_2$ with the atomic beam propagating on the axis of the laser beam b, and the atomic oven present on a line of extension of the axis of the laser beam b. For example, any of the following devisals (2-1) to (2-3) is necessary.

(2-1) A mirror is placed on a line slightly deviated from a location where the atomic beam passes so as to not block the propagation of the laser beam b, and a reflected light of the laser beam $a_1$ (that is, the laser beam $a_2$) is generated.
(2-2) A mirror with a hole for passing the atomic beam is placed so as not to block the propagation of the laser beam b, and a reflected light of the laser beam $a_1$ (that is, the laser beam $a_2$) is generated.
(2-3) A mirror is placed near a location where the laser beam b passes so as not to block the propagation of the laser beam b, and a laser beam is illuminated from outside and reflected by the mirror so as to generate a reflected light of the laser beam $a_1$ (that is, the laser beam $a_2$).

All of these methods have a problem in that the structures are complicated.

In Related Art (3), a structure for actually generating the four laser beams $a_1$, $a_2$, $a_3$, and $a_4$ toward a position where the atoms are trapped (actual equipment) will be considered. In the following, Actual Equipment (3-1) and Actual Equipment (3-2) will be considered.

In Actual Equipment (1), a plurality of mirrors are placed, and laser beams $a_1$, $a_2$, $a_3$, and $a_4$ are generated by reflections by the plurality of mirrors. For example, the laser beam $a_2$ is generated from the laser beam $a_1$, the laser beam as is generated from the laser beam $a_2$, the laser beam $a_4$ is generated from the laser beam $a_3$, and the laser beams $a_1$, $a_2$, $a_3$, and $a_4$ are interconnected. In order to generate the laser beam $a_2$ from the laser beam $a_1$ (that is, in order to change the position and the direction of the laser beam $a_1$ to the position and the direction of the laser beam $a_2$), at least two mirrors are necessary. Therefore, a total of eight mirrors are necessary. The eight mirrors cannot be placed on one plane, and must be placed three-dimensionally, which results in an increase in the size of the apparatus.

In Actual Equipment (3-2), for example, a laser beam which propagates in parallel with the laser beam $a_1$ and having a large beam waist is used, and three mirrors are placed in one plane orthogonal to the direction of propagation of the laser beam $a_1$. By the laser beam with large beam waist being reflected by one mirror, the laser beam $a_2$ can be

generated. The laser beams $a_3$ and $a_4$ are generated in a similar manner. In addition, with the laser beam with large beam waist, the laser beam $a_1$ can also be generated.

However, in Actual Equipment (3-2), it is necessary to use, as the laser beam with the large beam waist, a laser beam having a larger power in comparison to a total sum of the powers of the four laser beams used in Actual Equipment (3-1). This is because the laser beam with large beam waist must also be illuminated to a space other than the space through which the laser beams $a_1$, $a_2$, $a_3$, and $a_4$ propagate. This is similarly true for a configuration in which an equilateral triangular grating on which a plurality of grooves are formed is used in place of the three mirrors.

As described, in the related art, it has been difficult to reduce the size of the apparatus which realizes the magneto-optical trap.

An advantage of the present disclosure lies in reduction of the size of the magneto-optical trap apparatus with a simple structure.

SOLUTION TO PROBLEM

According to one aspect of the present disclosure, there is provided a magneto-optical trap apparatus which traps atoms with a magnetic field formed in a trap space in which atoms are trapped, and a plurality of laser beams supplied to the trap space, the magneto-optical trap apparatus comprising: a first illumination portion that illuminates at least three laser beams which propagate on a same plane to the trap space; and a second illumination portion that illuminates two laser beams which intersect the plane to the trap space.

The first illumination portion may illuminate the at least three laser beams which propagate on the same plane to the trap space with angles between the laser beams being equal to each other.

The first illumination portion may generate the at least three laser beams which propagate on the same plane from one laser beam through reflections.

The first illumination portion may include a plurality of mirrors, and the plurality of mirrors may be placed in such a manner that the at least three laser beams which propagate on the same plane are illuminated to the trap space with angles between the laser beams being equal to each other.

One laser beam of the at least three laser beams which propagate on the same plane may be used also as a laser beam of a Zeeman slower which decelerates an atomic beam with a laser beam and a magnetic field.

The second illumination portion may illuminate the two laser beam which intersect the plane to the trap space from directions opposite from each other.

The second illumination portion may reflect one laser beam of the two laser beams which intersect the plane, to generate the other laser beam of the two laser beams.

The plane may be a plane which passes through a point of symmetry of a magnetic field formed in the trap space for trapping atoms.

According to another aspect of the present disclosure, there is provided a physics package comprising the magneto-optical trap apparatus.

According to another aspect of the present disclosure, there is provided a physics package for an optical lattice clock, comprising the physics package.

According to another aspect of the present disclosure, there is provided a physics package for an atomic clock, comprising the physics package.

According to another aspect of the present disclosure, there is provided a physics package for an atomic interferometer, comprising the physics package.

According to another aspect of the present disclosure, there is provided a physics package for a quantum information processing device for atoms or ionized atoms, comprising the physics package.

According to another aspect of the present disclosure, there is provided a physics package system comprising the physics package, and a control apparatus that controls an operation of the physics package.

ADVANTAGEOUS EFFECTS

According to an aspect of the present disclosure, a size of a magneto-optical trap apparatus can be reduced with a simple structure.

BRIEF DESCRIPTION OF DRAWINGS

FIG. 1 is a block diagram showing an overall structure of an optical lattice clock according to an embodiment of the present disclosure.

FIG. 2A is a perspective diagram showing an overview of a magneto-optical trap apparatus according to an embodiment of the present disclosure.

FIG. 2B is a perspective diagram showing an overview of the magneto-optical trap apparatus according to the embodiment of the present disclosure.

FIG. 3 is a plan view showing an overview of the magneto-optical trap apparatus according to the embodiment, viewed from a direction of a Z axis.

FIG. 4 is a perspective diagram showing a physics package according to an embodiment of the present disclosure.

FIG. 5 is a plan view showing the physics package according to the embodiment of the present disclosure, viewed from a Z axis direction.

FIG. 6 is a cross-sectional diagram showing the physics package according to the embodiment of the present disclosure.

FIG. 7 is a diagram showing an upper lid and a lower lid.

FIG. 8 is a diagram showing a splitter.

FIG. 9 is a diagram showing a circulator.

FIG. 10 is a perspective diagram showing a group of mirrors and a group of laser beams according to an embodiment of the present disclosure.

FIG. 11 is a perspective diagram showing a group of mirrors and a group of lasers according to an alternative configuration.

FIG. 12 is a perspective diagram showing a plurality of laser beams in Related Art (1).

FIG. 13 is a perspective diagram showing a plurality of laser beams in Related Art (2).

FIG. 14 is a perspective diagram showing a plurality of laser beams in Related Art (3).

DESCRIPTION OF EMBODIMENTS

<Structure of Optical Lattice Clock>

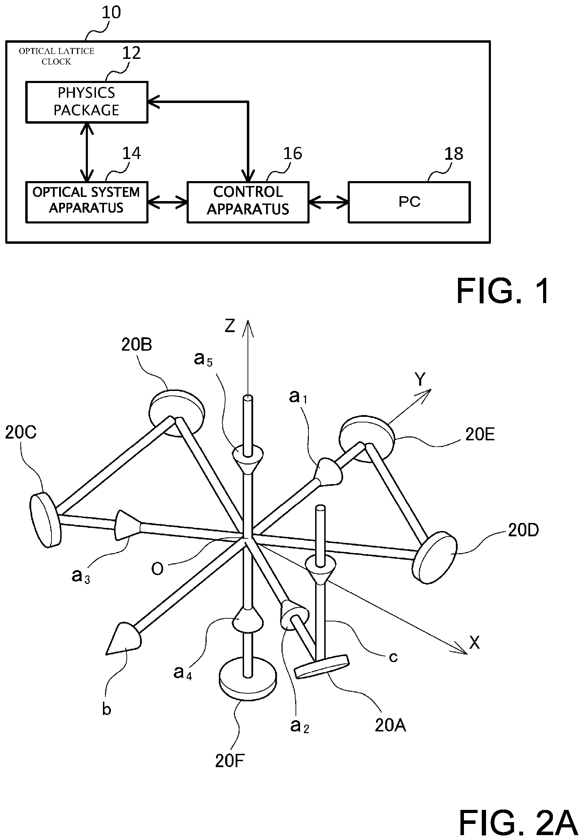

A schematic structure of an optical lattice clock 10 for which a magneto-optical trap apparatus according to an embodiment of the present disclosure is used will now be described with reference to FIG. 1. FIG. 1 is a block diagram showing an overall structure of the optical lattice clock 10. Here, an optical lattice clock 10 will be described as an example of an apparatus for which the magneto-optical trap apparatus is used, but alternatively, the magneto-optical trap apparatus according to the embodiment of the present disclosure may be used for apparatuses other than the optical lattice clock 10.

The optical lattice clock 10 includes, for example, a physics package 12, an optical system apparatus 14, a control apparatus 16, and a PC (Personal Computer) 18.

The physics package 12 is an apparatus which traps an atomic cloud, entraps the atomic cloud in an optical lattice, and causes a clock transition. The optical system apparatus 14 is an apparatus having optical devices such as a laser beam source for trapping atoms, a laser beam source for exciting clock transition, a laser frequency control apparatus, and the like. The optical system apparatus 14 applies processes, in addition to sending a laser beam to the physics package 12, to receive a fluorescence signal emitted from the atomic cloud in the physics package 12, to convert the received signal into an electrical signal, and to feed back to the laser beam source so that the frequency matches the resonance frequency of the atom. The control apparatus 16 is an apparatus which controls the physics package 12 and the optical system apparatus 14. The control apparatus 16 applies, for example, operation control of the physics package 12, operation control of the optical system apparatus 14, and an analysis process such as frequency analysis of the clock transition obtained through measurement. The physics package 12, the optical system apparatus 14, and the control apparatus 16 cooperate with each other, to realize the functions of the optical lattice clock 10.

The PC 18 is a general-purpose computer including one or more processors and a memory. Software is executed by hardware including the one or more processors and the memory, to realize the functions of the PC 18. In the PC 18, an application program for controlling the optical lattice clock 10 is installed. The PC 18 is connected to the control apparatus 16, and may control not only the control apparatus 16, but also the entirety of the optical lattice clock 10 including the physics package 12 and the optical system apparatus 14. In addition, the PC 18 provides a UI (User Interface) of the optical lattice clock 10. A user can start the optical lattice clock 10, apply time measurement, and check results through the PC 18.

A system including the physics package 12 and a structure necessary for control of the physics package 12 may sometimes be called a "physics package system". The structure necessary for the control may be included in the control apparatus 16 or in the PC 18, or in the physics package 12. Alternatively, a part or all of the functions of the control apparatus 16 may be included in the physics package 12.

<Overview of Magneto-Optical Trap Apparatus of Embodiment>

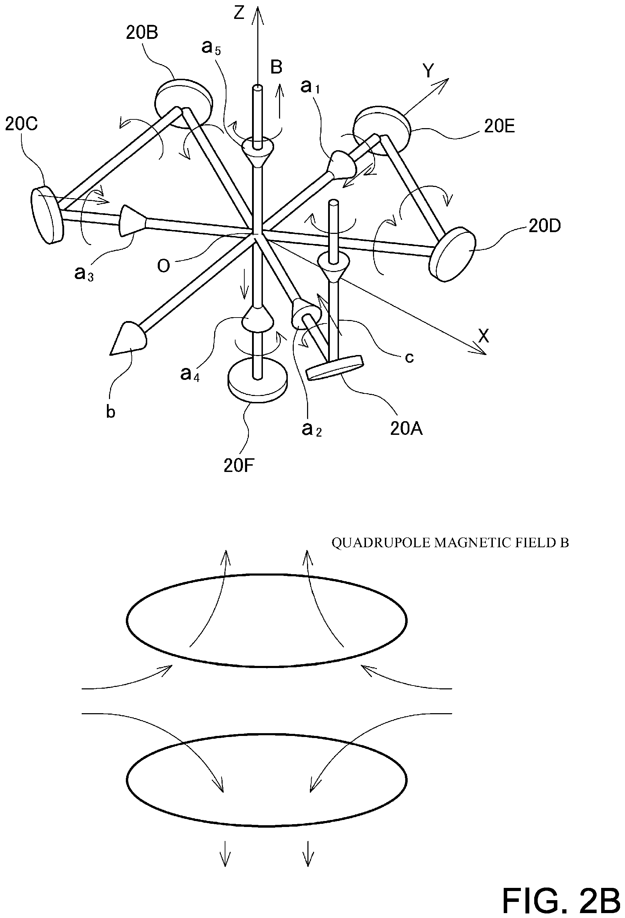

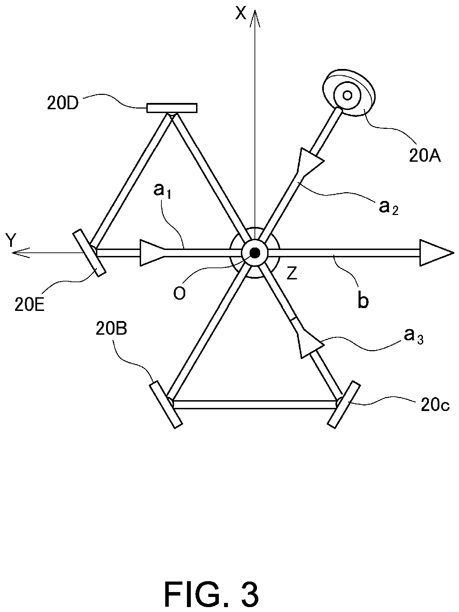

An overview of a magneto-optical trap apparatus according to an embodiment of the present disclosure will now be described with reference to FIGs. 2A, 2B, and 3. FIGs. 2A, 2B, and 3 show a plurality of laser beams illuminated in the magneto-optical trap apparatus according to the embodiment, and a plurality of mirrors (an example of optical elements). FIGs. 2A, 2B, and 3 show the Cartesian coordinate system (X axis, Y axis, and Z axis which are orthogonal to each other). FIGs. 2A and 2B are perspective diagrams showing placement of the plurality of mirrors. FIG. 3 is a plan view showing the placement of the plurality of mirrors, viewed from a direction of the Z axis.

A point where the X axis, the Y axis, and the Z axis intersect each other is defined as a center O of a trap space. The center O coincides with a point of symmetry of a magnetic field for the magneto-optical trap.

The magneto-optical trap apparatus according to the embodiment includes a first illumination portion that illuminates at least three laser beams which propagate on a same plane to the trap space, and a second illumination portion that illuminates two laser beams which intersect the plane to the trap space. The trap space is a space in the magneto-optical trap apparatus, where atoms are trapped by a magneto-optical trap realized by a magnetic field and a plurality of laser beams.

In the example configuration illustrated in FIGs. 2A, 2B, and 3, five laser beams (laser beams $a_1$, $a_2$, $a_3$, $a_4$, and $a_5$) are used as laser beams for the magneto-optical trap, and one of these laser beams (laser beam b) is used also as a laser beam for Zeeman deceleration. Here, as an example, the laser beam $a_1$ is used also as the laser beam b for Zeeman deceleration.

Directions of propagation of the laser beams $a_1$, $a_2$, $a_3$, $a_4$, and $a_5$ are defined by following Equation (5).

[Equation (5)]

$$\vec{a}_1 = -\vec{y} ,$$

$$\vec{a}_2 = -\frac{\sqrt{3}}{2}\vec{x} + \frac{1}{2}\vec{y} ,$$

$$\vec{a}_3 = \frac{\sqrt{3}}{2}\vec{x} + \frac{1}{2}\vec{y} ,$$

$$\vec{a}_4 = \vec{z} ,$$

$$\vec{a}_5 = -\vec{z} ,$$

$$\vec{b} = -y .$$

A laser beam c which is illuminated from outside of the magneto-optical trap apparatus to an inside of the magneto-optical trap apparatus is reflected by a mirror 20A toward the center O of the trap space. The laser beam reflected by the mirror 20a is the laser beam $a_2$. A mirror 20B is placed at a side opposite from the mirror 20A with the center O therebetween. The laser beam $a_2$ which has passed through the center O is reflected by the mirror 20B toward a mirror 20C, and is further reflected by the mirror 20C toward the center O of the trap space. The laser beam reflected by the mirror 20C is the laser beam as. A mirror 20D is placed at a side opposite from the mirror 20C with the center O therebetween. The laser beam as which has passed through the center O is reflected by the mirror 20D toward a mirror 20E, and is further reflected by the mirror 20E toward the center O of the trap space, The laser beam reflected by the mirror 20E is the laser beam $a_1$. The laser beam $a_1$ passes through the center O, propagates to the Zeeman slower, and is illuminated into the Zeeman slower as the laser beam b for Zeeman deceleration. In this manner, the laser beam $a_1$ for the magneto-optical trap is also used as the laser beam b for Zeeman deceleration.

The laser beams $a_1$, $a_2$, and as are laser beams which propagate in one Z plane (plane orthogonal to the Z axis) including the axis of the atomic beam. The mirrors 20A, 20B, 20C, 20D, and 20E are placed in such a manner that the laser beam c illuminated from the outside of the magneto-optical trap apparatus to the inside of the magneto-optical trap apparatus propagates on the Z plane which is the same plane. In this manner, three laser beams which propagate on the Z plane are generated.

The mirrors 20A, 20B, 20C, 20D, and 20E correspond to an example of the first illumination portion. The first illumination portion illuminates the laser beams $a_1$, $a_2$, and as which propagate on the Z plane which is the same plane toward the center O of the trap space, with angles between the laser beams being equal to each other. The angle is, for example, 120°. That is, the mirrors 20A, 20B, 20C, 20D, and 20E are placed such that the angles formed by the laser beams $a_1$, $a_2$, and $a_3$ are 120°.

In addition, the first illumination portion generates three laser beams (laser beams $a_1$, $a_2$, and $a_3$) which propagate on the Z plane which is the same plane, from one laser beam c through reflection. In other words, the laser beam c illuminated from the outside of the magneto-optical trap apparatus to the inside of the magneto-optical trap apparatus is sequentially reflected by the mirror 20A, 20B, 20C, 20D, and 20E, and three laser beams (laser beams $a_1$, $a_2$, and $a_3$) which propagate on the Z plane are generated through these reflections.

Further, a laser beam as is illuminated along the Z axis and from a direction opposite from the direction of the Z axis, toward the center O. The laser beam as which has passed through the center O is reflected by a mirror 20F. The mirror 20F is placed in such a manner to reflect the laser beam as to a direction opposite from the direction of propagation of the laser beam as. The laser beam reflected by the mirror 20F is the laser beam $a_4$. The laser beam $a_4$ propagates along the Z axis in a direction opposite from the direction of propagation of the laser beam $a_5$, passes through the center O, and is illuminated to the outside of the magneto-optical trap apparatus.

In the manner described above, two laser beams (laser beams $a_4$ and $a_5$) are illuminated to the trap space. The laser beams $a_4$ and $a_5$ are laser beams intersecting the Z plane, and are laser beams which propagate in directions opposite from each other. In the example configuration illustrated in FIGs. 2A, 2B, and 3, the laser beams $a_4$ and $a_5$ are laser beams orthogonal to the Z plane.

The mirror 20F is an example of the second illumination portion. The second illumination portion illuminates two laser beams (laser beams $a_4$ and $a_5$) orthogonal to the Z plane from directions opposite from each other toward the center O. That is, the mirror 20F is placed in such a manner that two laser beams orthogonal to the Z plane are illuminated from directions opposite from each other toward the center O.

In addition, the second illumination portion reflects one laser beam as of the two laser beams, to generate the other laser beam $a_4$ of the two laser beams.

Alternatively, the laser beams $a_1$, $a_2$, $a_3$, $a_4$, and as may be generated from one laser beam using mirrors and beam splitters. For example, the laser beam as is illuminated to the inside of the magneto-optical trap apparatus, the laser beam $a_4$ is generated by the mirror 20F reflecting the laser beam $a_5$, and the laser beam $a_4$ is illuminated to the outside of the magneto-optical trap apparatus. The laser beam $a_4$ illuminated to the outside of the magneto-optical trap apparatus is reflected by a mirror placed at the outside of the magneto-optical trap apparatus, so that the laser beam c is generated. When the laser beam c is illuminated to the inside of the magneto-optical trap apparatus, the laser beams $a_2$, $a_3$, and $a_1$ are sequentially generated in the manner described above. In this manner, the laser beams may be sequentially generated and illuminated from one laser beam.

Polarizations of the laser beams forming the magneto-optical trap apparatus will now be described. In the configuration of the laser beams of the six directions shown in FIG. 12, opposing laser beams must be set in circular polarizations of opposite directions. With regard to laser beams $\{a_1, a_2, a_3, a_4\}$ on the XY plane, in an example configuration which is commonly employed in the related art, $a_2$ ($a_4$) having circular polarization opposite from $a_1$ ($a_3$) is generated as a reflected light of $a_1$ ($a_3$) by introducing a $\lambda/4$ mirror. In another example configuration, (1) $a_1$ is used as incident light, (2) two mirrors are placed in the path of propagation of $a_1$, to generate $a_4$, (3) a $\lambda/4$ mirror is placed in the path of propagation of $a_4$, to generate as as a reflected light thereof, and (4) the reflected light propagates in a path with the two mirrors in (2), to generate $a_2$. In these examples, in order to satisfy the condition of polarization, at least one $\lambda/4$ mirror must be prepared in order to generate the laser beams $\{a_1, a_2, a_3, a_4\}$ in the XY plane.

FIG. 2B shows a structure of five laser beams according to the embodiment, and left and right circular polarizations thereof. Arrows in FIG. 2B show directions of the circular polarization. The circular polarization corresponds to a quadrupole magnetic field B. FIG. 2B shows, for convenience of explanation, the quadrupole magnetic field B. The laser beams $\{a_1, a_2, a_3, a_4, b\}$ on the XY plane are generated with $a_1$ as the incident light and through a path with the mirrors 20A, 20B, 20C, 20D, and 20E. Here, the mirrors 20A, 20B, 20C, 20D, and 20E are polarization independent mirrors which do not change the polarization. In the embodiment, a $\lambda/4$ mirror in the XY plane is not necessary.

The structure and placement of the plurality of mirrors illustrated in FIGs. 2A, 2B, and 3 are merely an example, and the structure and the placement of the plurality of mirrors may be changed so long as the laser beams $a_1$, $a_2$, $a_3$, $a_4$, $a_5$, and b illustrated in FIGs. 2A, 2B, and 3 are generated. For example, a certain mirror may be used also as another mirror, and the other mirror may be omitted. Alternatively, a beam splitter may be used to generate the plurality of laser beams.

<Physical Package including Magneto-Optical Trap Apparatus of Embodiment>

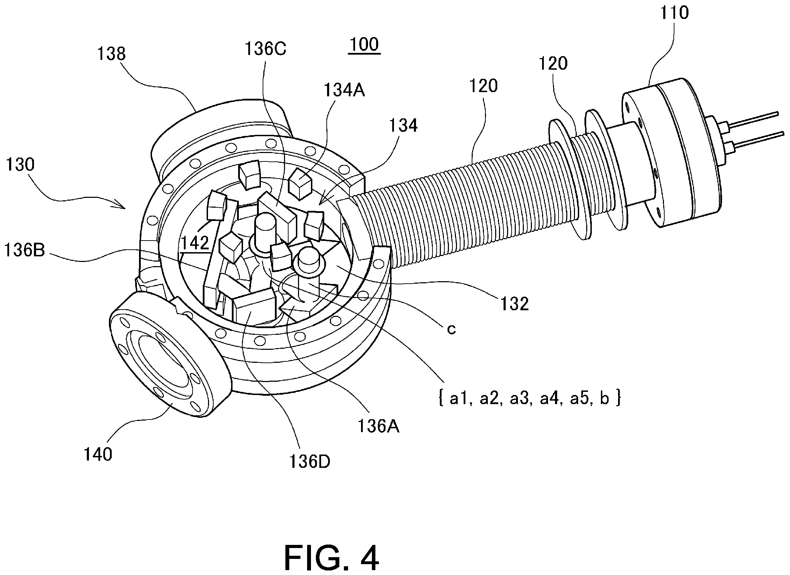

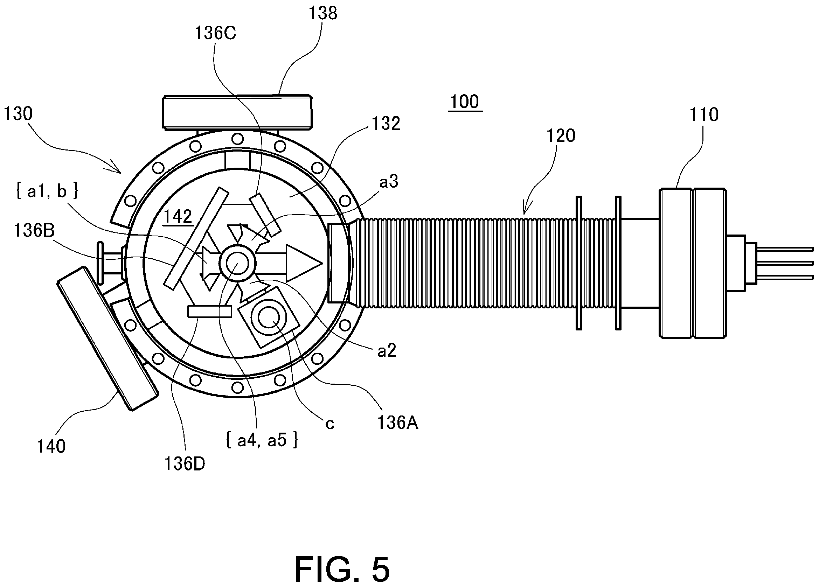

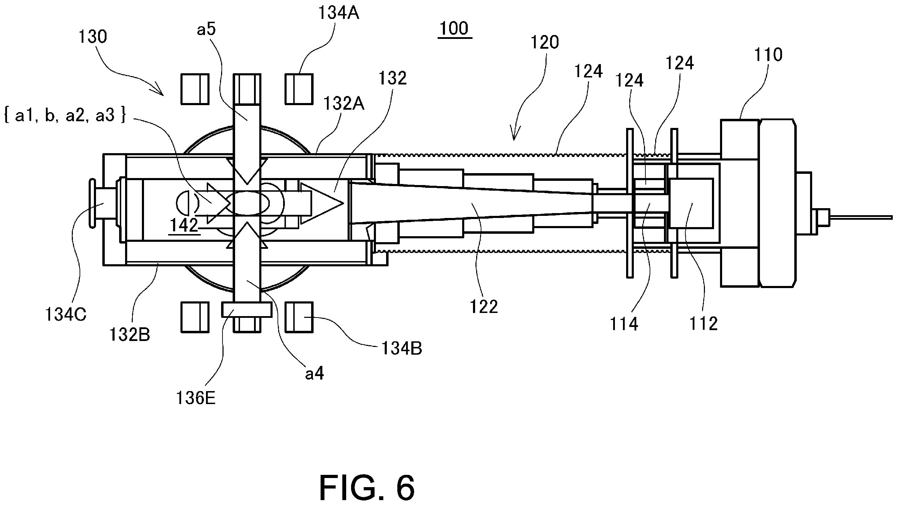

The magneto-optical trap apparatus according to an embodiment of the present disclosure will now be described with reference to FIGs. 4 to 6. FIG. 4 is a perspective diagram showing a physics package. FIG. 5 is a plan view of the physics package, viewed from the direction of the Z axis. FIG. 6 is a cross-sectional diagram of the physics package, cutting the physics package with a plane including the axis of the atomic beam.

A physics package 100 according to an embodiment of the present disclosure includes an atomic oven 110, a Zeeman slower 120, and a magneto-optical trap apparatus 130.

The atomic oven 110 includes a sample reservoir 112 in which a sample is housed, a heater, a thermometer, an electrical connector, a capillary nozzle 114, a thermal radiation shield, and the like. When the sample is heated with the heater, an atomic vapor is generated from the sample. The atomic beam is emitted from the capillary nozzle 114 toward the Zeeman slower 120. By the atomic beam being emitted from the capillary nozzle 114, an atomic beam is collimated with a directionality. As the sample, for example, strontium, ytterbium, or the like is used, but alternatively, other atoms may be used as the sample.

The Zeeman slower 120 includes a bore 122 and a magnetic field generator 124. The magnetic field generator 124 includes a solenoid coil, and generates a magnetic field along a center axis of the bore 122. The atomic beam emitted from the atomic oven 110 is illuminated into the bore 122.

The Zeeman slower 120 decelerates, with Zeeman deceleration, a velocity of the atomic beam emitted from the atomic oven 110 and having a large initial velocity to a velocity at which the atomic beam can be trapped by the magneto-optical trap apparatus (MOT apparatus) 130 in the second stage.

A slowing laser beam b is illuminated in the bore 122 from a direction opposite from the direction of propagation of the atomic beam. As described above, the slowing laser beam b is a laser beam which is used also as the laser beam $a_1$ for the magneto-optical trap. In addition, the magnetic field generator 124 forms a magnetic field with a spatial gradient and centered at the bore 122, in accordance with Zeeman deceleration.

In the Zeeman slower 120, the velocity of the atomic beam illuminated from the atomic oven 110 into the bore 122 is decelerated by the magnetic field generated by the magnetic field generator 124 and the slowing laser beam b. A high-temperature atomic beam propagates in the bore 122 toward the magneto-optical trap apparatus 130 while being decelerated in accordance with Zeeman deceleration by the magnetic field generated by the magnetic field generator 124 and the slowing laser beam b.

As the atomic oven 110 and the Zeeman slower 120, a conventional atomic oven and a conventional Zeeman slower may be employed.

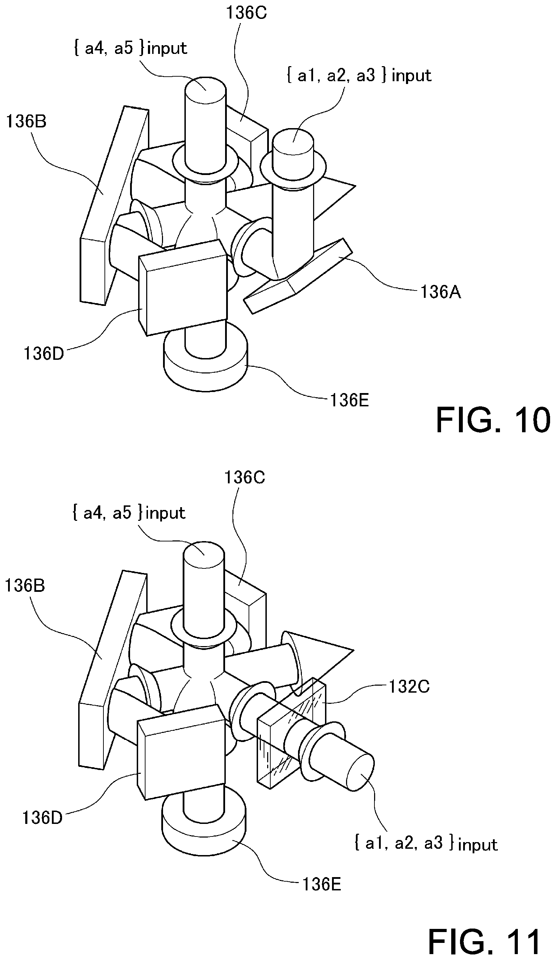

The magneto-optical trap apparatus 130 includes a vacuum chamber 132, a magnetic field generator 134, and a plurality of optical elements (for example, a mirror, a beam splitter, or the like). Here, as an example of the optical elements, mirrors 136A, 136B, 136C, 136D, and 136E are used, but alternatively, a beam splitter may be used. FIG. 10 also shows the mirrors 136A, 136B, 136C, 136D, and 136E according to the embodiment.

In the vacuum chamber 132, a vacuum discharge port 138, and an auxiliary port 140 are provided. A vacuum pump is connected to the vacuum exhaust port 138, and the vacuum chamber 132 is vacuumed by the vacuum pump, so as to maintain ultra-high vacuum in the vacuum chamber 132. The inside of the vacuum chamber 132 is connected to the bore 122 in the Zeeman slower 120 and the sample chamber 112 of the atomic oven 110, and the bore 122 and the sample chamber 122 are thus maintained in the ultra-high vacuum state. A window provided on the vacuum chamber 132 is provided on the vacuum chamber 132 via a gasket such as, for example, an indium seal.

In a space 142 in the vacuum chamber 132, a trap space in which the atoms are trapped is formed.

The magnetic field generator 134 includes, for example, a permanent magnet or a coil, and generates a quadrupole magnetic field in the trap space of the atom.

As shown in FIG. 6, for example, the magnetic field generator 134 includes a pair of groups of permanent magnets (groups of permanent magnets 134A and 134B). The groups of permanent magnets 134A and 134B are placed at the outside of the vacuum chamber 132, and with the vacuum chamber 132 therebetween. In the example configuration illustrated in FIG. 6, the group of permanent magnets 134A is placed on a side of an upper lid 132A (upper surface at which the laser beam as is incident) of the vacuum chamber 132, and the group of permanent magnets 134B is placed on a side of a lower lid 132B (lower surface at which the laser beam $a_4$ is incident) of the vacuum chamber 132.

As the magnetic field generator 134, an anti-Helmholtz coil formed from a pair of electromagnetic coils may be employed. As another example, four permanent magnets placed on a side surface of the vacuum chamber 132 may be used as the magnetic field generator 134. Each permanent magnet is magnetized in a radius vector direction. Alternatively, 2n (wherein n=2, 3, 4, ...) permanent magnets magnetized in the radius vector direction may be used as the magnetic field generator 134.

The mirrors 136A, 136B, 136C, and 136D are placed inside the vacuum chamber 132, and the mirror 136E is placed at the outside of the vacuum chamber 132, on the side of the lower lid 132B of the vacuum chamber 132.

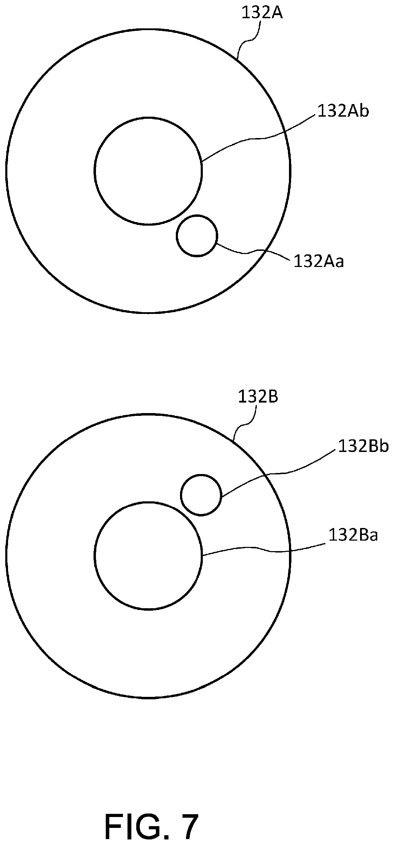

Windows through which the laser beams pass are provided on the upper lid 132A and the lower lid 132B of the vacuum chamber 132. FIG. 7 shows the upper lid 132A and the lower lid 132B. FIG. 7 is a plan view showing the upper lid 132A and the lower lid 132B.

On the upper lid 132A, for example, windows 132Aa and 132Ab are provided. On the lower lid 132B, for example, windows 132Ba and 132Bb are provided. The window 132Aa is provided on the upper lid 132A at a position corresponding to the mirror 136A. The window 132Ab is provided on the upper lid 132A at a position corresponding to the Z axis. The window 132Ba is provided on the lower lid 132B at a position on the Z axis.

In the magneto-optical trap apparatus 130, as described above with reference to FIGs. 2A, 2B, and 3, five laser

beams (laser beams $a_1$, $a_2$, $a_3$, $a_4$, and $a_5$) are used as the laser beams for the magneto-optical trap, and one of these laser beams (also called slowing laser beam b) is also used as the laser beam for Zeeman deceleration. Here, as an example, the laser beam $a_1$ is also used as the slowing laser beam b for Zeeman deceleration.

The laser beam c is illuminated from the outside of the vacuum chamber 132 through the window 132Aa of the upper lid 132A into the vacuum chamber 132. In the space 142 in the vacuum chamber 132, the mirror 136A is placed at a position corresponding to the illumination position of the laser beam c. The laser beam c is reflected by the mirror 136A toward the center O of the trap space. The laser beam reflected by the mirror 136A is the laser beam $a_2$. The mirror 136B is placed at a side opposite from the mirror 136A with the center O therebetween. The laser beam $a_2$ which has passed through the center O is reflected by the mirror 136B toward the mirror 136C, and is further reflected by the mirror 136C toward the center O of the trap space. The laser beam reflected by the mirror 136C is the laser beam as. The mirror 136D is placed at a side opposite from the mirror 136C with the center O therebetween. The laser beam as which has passed through the center O is reflected by the mirror 136D toward the mirror 136B, and is further reflected by the mirror 136B toward the center O of the trap space. The laser beam reflected by the mirror 136B is the laser beam $a_1$. The laser beam $a_1$ passes through the center O, is emitted from a hole formed on a side surface of the vacuum chamber 132, and is illuminated into the bore 122 of the Zeeman slower 120 as the slowing laser beam b. In this manner, the laser beam $a_1$ for the magneto-optical trap is used also as the slowing laser beam b for Zeeman deceleration.

The laser beam $a_1$ propagates on the axis of the atomic beam emitted from the atomic oven 110, and is used in the Zeeman slower 120 as the slowing laser beam b for Zeeman deceleration.

The laser beams $a_1$, $a_2$, and $a_3$ are laser beams which propagate in one Z plane including the axis of the atomic beam. The mirrors 136A, 136B, 136C, and 136D are placed in such a manner that the laser beam c propagates on the Z plane which is the same plane. In this manner, three laser beams propagating on the Z plane are generated.

The mirrors 136A, 136B, 136C, and 136D correspond to an example of the first illumination portion. The laser beams $a_1$, $a_2$, and $a_3$ which propagate on the Z plane which is the same plane are illuminated toward the center O of the trap space with angles therebetween being equal to each other. The angle is, for example, 120°. That is, the mirrors 136A, 136B, 136C, and 136D are placed such that the angles formed by the laser beams $a_1$, $a_2$, and $a_3$ with each other are 120°.

Further, the laser beam c is sequentially reflected by the mirrors 136A, 136B, 136C, and 136D, and three laser beams (laser beams $a_1$, $a_2$, and $a_3$) which propagate on the Z plane are generated through the reflections.

The laser beam as is illuminated from the outside of the vacuum chamber 132 through the window 132Ab of the upper lid 132A into the vacuum chamber 132. The laser beam as is illuminated toward the center O. A position of the window 132Ab is adjusted so that the laser beam as is illuminated toward the center O. The laser beam as which has passed through the center O is illuminated through the window 132Ba of the lower lid 132B to the outside of the vacuum chamber 132. At the outside of the vacuum chamber 132, the mirror 136E is placed at a position corresponding to the window 132Ba, and the laser beam as is reflected by the mirror 136E. The mirror 136E is placed in such a manner that the laser beam as is reflected to a direction opposite the direction of propagation of the laser beam as. The laser beam reflected by the mirror 136E is again illuminated through the window 132Ba of the lower lid 132B into the vacuum chamber 132. The laser beam reflected by the mirror 136E is the laser beam $a_4$. The laser beam $a_4$ propagates along the Z axis in a direction opposite from the direction of propagation of the laser beam $a_5$, and passes through the center O. The laser beam $a_4$ which has passed through the center O is illuminated through the window 132Ab to the outside of the vacuum chamber 132.

In the manner described above, two laser beams (laser beams $a_4$ and $a_5$) are illuminated to the trap space. The laser beams $a_4$ and $a_5$ are laser beams orthogonal to the Z plane and which propagate in directions opposite from each other. The mirror 136E is an example of the second illumination portion. The mirror 136E is placed in such a manner that two laser beams orthogonal to the Z plane are illuminated toward the center O from directions opposite each other.

In each of the optical elements such as the mirror and the beam splitter, a wave plate may be provided so that a particular polarization is obtained. In addition, the positions (such as, for example, heights) of the optical elements such as the mirror and the beam splitter are adjusted according to a beam size of the laser beam. Each optical element may be, for example, adhered on the window of the vacuum chamber 132 using an optical adhesive or the like.

The center O of the region in which the laser beams $a_1$, $a_2$, $a_3$, $a_4$, and $a_5$ intersect (that is, the center O of the trap space) coincides with a point of symmetry of the quadrupole magnetic field formed by the magnetic field generator 134. The positions, shapes, sizes, and the like of the optical elements such as the mirror and the beam splitter, the magnetic field generator 134, and the windows of the vacuum chamber 132 are adjusted so that the center O of the region in which the laser beams $a_1$, $a_2$, $a_3$, $a_4$, and $a_5$ intersect coincides with the point of symmetry of the quadrupole magnetic field.

When the point of symmetry of the quadrupole field deviates due to leakage of the magnetic field used for Zeeman deceleration, an adjusting magnetic field may be generated by winding a coil wiring around a coil bobbin 134C for adjusting the magnetic field, and the point of symmetry may be finely adjusted.

A structure and a position of the magnetic field generator 134 are designed in such a manner that the magnetic field generator 134 does not block the propagation of the laser beams. For example, the groups of permanent magnets 134A and 134B are configured such that a portion where the laser beam c which is the origin of the laser beams $a_1$, $a_2$, and as is introduced into the vacuum chamber 132 (for example, a portion including the window 132Aa) does not interfere with the magnetic field generator 134. For example, each of the groups of permanent magnets 134A and 134B is created by dividing a ringshaped magnet into six pieces. With such a configuration, a passageway through which the laser beam passes is formed, and the laser beam propagates without being blocked by the magnetic field generator 134.

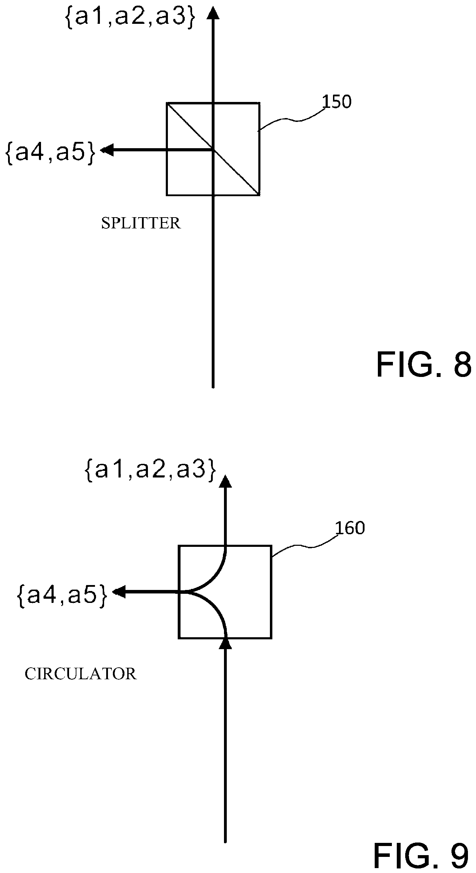

A mechanism for supplying the laser beams to the magneto-optical trap apparatus 130 will now be described with reference to FIGs. 8 and 9. FIG. 8 is a diagram showing a beam splitter 150, and FIG. 9 is a diagram showing a circulator 160.

In an example configuration illustrated in FIG. 8, the laser beam is split by the beam splitter 150 into two laser beams, and the two laser beams are supplied to the magneto-optical trap apparatus 130. One of the two laser beams is used as the laser beam for the laser beams $a_1$, $a_2$, and $a_3$ (for example, the laser beam c). The other of the two laser beams is used as the laser beam for the laser beams $a_4$ and $a_5$ (for example, the laser beam $a_5$).

In the example configuration illustrated in FIG. 9, the laser beam as which is the origin of the laser beams $a_4$ and $a_5$ is supplied by the circulator 160 to the magneto-optical trap apparatus 130. The laser beam $a_4$ which is the reflected light thereof is supplied by the circulator 130 to the magneto-optical trap apparatus 130 as the laser beam c.

The structures illustrated in FIGs. 8 and 9 are merely exemplary, and the laser beams may be supplied to the magneto-optical trap apparatus 130 by structures other than the structures illustrated in FIGs. 8 and 9.

According to the magneto-optical trap apparatus 130 of the embodiment, the following advantageous effects can be achieved.

In the magneto-optical trap apparatus 130 which operates under the ultra-high vacuum, with the reduction of the number of windows through which the laser beams pass, the structure of the vacuum chamber 132 can be simplified, and the size of the magneto-optical trap apparatus 130 can be reduced. In addition, with the placement of the members to be placed in the vacuum chamber 132 (for example, optical elements such as the mirror) in the same plane (for example, the Z plane) in place of the three-dimensional placement, the size of the magneto-optical trap apparatus 130 can be reduced.

In addition, in the embodiment, five laser beams are used, and the magneto-optical trap can be realized with a fewer number of laser beams in comparison to the related art in which six laser beams are used. In addition, one laser beam $a_1$ can be used also as the slowing laser beam b for Zeeman deceleration, to decelerate the atomic beam.

Moreover, in the related art which uses four laser beams, because a plurality of mirrors must be placed three-dimensionally in order to generate the four laser beams from one laser beam, it is difficult to reduce the size of the apparatus.

In the contrary, in the embodiment of the present disclosure, the magneto-optical trap can be realized by placing a plurality of mirrors on the same plane (for example, the Z plane), and placing one mirror on the Z axis orthogonal to the plane. Because the magneto-optical trap can be realized with such a simple structure, the size of the apparatus can be reduced. As the structure for this purpose, the windows illustrated in FIG. 7 or the structure illustrated in FIG. 11 is employed. According to these structures, because the number of windows to be provided on the vacuum chamber 132 can be reduced, the size of the apparatus can be reduced.

An alternative configuration of the structure for supplying the laser beam into the vacuum chamber 132 will now be described with reference to FIGs. 10 and 11. FIG. 10 shows a group of mirrors and a group of laser beams illustrated in FIG. 4. FIG. 11 shows a group of mirrors and a group of laser beams according to the alternative configuration.

In the example configuration illustrated in FIG. 4, the laser beams c and as are illuminated through the window 132Aa of the upper lid 132A into the vacuum chamber 132 (refer to FIG. 10).

In the alternative configuration, as shown in FIG. 11, an optical port 132C such as a window is provided on a side surface of the vacuum chamber 132, and the laser beam $a_1$ is illuminated through the optical port 132C into the vacuum chamber 132. The laser beam as is illuminated through the window 132Aa into the vacuum chamber 132, similar to the example configuration shown in FIG. 10.

In general, when the number of windows provided on the vacuum chamber 132 is increased, a volume of the vacuum chamber 132 is increased because members such as vacuum seal is placed. Because the number of windows in the structure illustrated in FIG. 10 is fewer than the structure illustrated in FIG. 11 by one, the structure of FIG. 10 contributes to the reduction of the size of the apparatus.

On the other hand, according to the structure illustrated in FIG. 11, because the laser beam $a_1$ is illuminated from the side surface of the vacuum chamber 132 into the vacuum chamber 132, it is more difficult for an interference with the magnetic field generator 134 to occur. That is, because the group of permanent magnets 134A is placed on the side of the upper lid 132A and the group of permanent magnets 134B is placed on the side of the lower lid 132B, when the laser beam $a_1$ is illuminated through the side surface of the vacuum chamber 132 into the vacuum chamber 132, the laser beam $a_1$ does not tend to interfere with the groups of permanent magnets 134A and 134B. As a result, the design of the magnetic field generator 134 (for example, the placement) can be facilitated.

<Operation of Physical Package>

An operation of the physics package 12 of the optical lattice clock according to an embodiment of the present disclosure will now be described. Similar to a physics package 100, the physics package 12 includes the atomic oven 110, the Zeeman slower 120, and the magneto-optical trap apparatus 130, and realizes a magneto-optical trap and clock transition. The operation of the physics package 12 will now be described. The operation of the physics package 100 is similar to the physics package 12.

In the physics package 12, inside of the vacuum chamber 132 is set to be vacuum. The atomic beam emitted from the atomic oven 110 to the Zeeman slower 120 is sufficiently decelerated in accordance with Zeeman deceleration, and reaches the magneto-optical trap apparatus 130. In the Zeeman slower 120, the slowing laser beam b described above is used, and the atomic beam is decelerated.

In the magneto-optical trap apparatus 130, the magnetic field generator 134 forms the magnetic field with a linear spatial gradient, centered at the trap space in which the atoms are trapped, and the laser beams $a_1$, $a_2$, $a_3$, $a_4$, and $a_5$ are illuminated as MOT beams. The atoms are trapped in the trap space by the magnetic field formed by the magnetic field generator 134 and the laser beams $a_1$, $a_2$, $a_3$, $a_4$, and $a_5$ which are MOT beams. A slow atomic beam reaching the magneto-optical trap apparatus 130 is further decelerated in the trap space, and, with this process, the atomic cloud is trapped in the trap space. In addition, the laser beam forming the optical lattice in an optical cavity installed in the vacuum chamber creates optical lattice potentials in the trap space, in which standing waves exist in the direction of propagation of the optical lattice laser beams. Atom clouds are trapped in the optical lattice potential.

By slightly changing a wavelength, the optical lattice can be moved in the direction of propagation of the optical lattice laser beam. With this moving means by the moving optical lattice, the atomic cloud is moved into a clock transition space. The clock transition space can be isolated from a beam axis of the slow atomic beam.

In the clock transition space, a laser beam whose optical frequency is controlled is illuminated to the atoms, high-precision high precision atomic spectroscopy and interrogation of the clock transition (that is, resonance transition of the atom which forms a reference of the clock) is performed, and an atomic specific frequency is measured. With this process, an accurate atomic clock is realized. Alternatively, in the case that it is not necessary to move the atomic cloud from the trap space to the clock transition space, the spectroscopy and interrogation may be performed in the trap space.

In order to improve the precision of the atomic clock, it is necessary to remove fluctuation around the atoms, and accurately read the frequency. Of the particular importance is removal of a frequency shift caused by Doppler's effect due to thermal motion of the atoms. In the optical lattice clock, the motion of the atoms is frozen by trapping the atoms in the optical lattice created by interference of laser beams in a space sufficiently small in comparison to the wavelength of the clock laser. On the other hand, in the optical lattice, the frequency of the atom is shifted due to the laser beams forming the optical lattice. In this regard, a particular wavelength and a particular frequency called a "magic wavelength" or a "magic frequency" are selected for the optical lattice light beam so as to remove the influences of the optical lattice on the resonance frequency.

The light emitted as a result of the clock transition is received by the optical system apparatus 14, and spectroscopically processed or the like by the control apparatus 16, to determine the frequency.

In the above description, the optical lattice clock has been exemplified. However, those skilled in the art can apply the technique of the embodiment to structures other than the optical lattice clock. Specifically, the technique may be applied to atomic clocks other than the optical lattice clock, or an atomic interferometer which is an interferometer using atoms. For example, a physics package for an atomic clock or a physics package for an atomic interferometer including the magneto-optical trap apparatus 130 of the embodiment may be formed. Further, the present embodiment can be applied to various quantum information processing devices for atoms or ionized atoms. The quantum information processing device is a device which performs measurement, sensing, and information processing using quantum states of atoms and light, and, in addition to the atomic clock and the atomic interferometer, there may be exemplified a magnetic field meter, an electric field meter, a quantum computer, a quantum simulator, a quantum relay, and the like. In a physics package for a quantum information processing device, with the technique of the embodiment, size reduction or transportability can be achieved, similar to the physics package for the optical lattice clock. It should be noted that, in these devices, the clock transition space may be handled not as a space targeted for time measurement, but as a space in which atomic spectroscopy and interrogation of clock transition is caused.

In the description above, a specific configuration has been described in order to facilitate understanding. These descriptions, however, merely exemplify the embodiment, and various other embodiments are also possible.

REFERENCE SIGNS LIST

10 optical lattice clock, 12 physics package, 14 optical system apparatus, $a_1$, $a_2$, $a_3$, $a_4$, $a_5$, b laser beam, 136A, 136B, 136C, 136D, 136E mirror

**Claims**

1. A magneto-optical trap apparatus which traps atoms with a magnetic field formed in a trap space in which atoms are trapped, and a plurality of laser beams supplied to the trap space, the magneto-optical trap apparatus comprising:

   a first illumination portion that illuminates at least three laser beams which propagate on a same plane to the trap space; and
   a second illumination portion that illuminates two laser beams which intersect the plane to the trap space.

2. The magneto-optical trap apparatus according to claim 1, wherein
   the first illumination portion illuminates the at least three laser beams which propagate on the same plane to the trap space with angles between the laser beams being equal to each other.

3. The magneto-optical trap apparatus according to claim 1 or 2, wherein
   the first illumination portion generates the at least three laser beams which propagate on the same plane from one laser beam through reflections.

4. The magneto-optical trap apparatus according to claim 3, wherein

   the first illumination portion includes a plurality of mirrors, and
   the plurality of mirrors are placed in such a manner that the at least three laser beams which propagate on the same plane are illuminated to the trap space with angles between the laser beams being equal to each other.

5. The magneto-optical trap apparatus according to any one of claims 1 to 4, wherein
   one laser beam of the at least three laser beams which propagate on the same plane is used also as a slowing laser beam of Zeeman slower which decelerates an atomic beam with a laser beam and a magnetic field.

6. The magneto-optical trap apparatus according to any one of claims 1 to 5, wherein
   the second illumination portion illuminates the two laser beams which intersect the plane to the trap space from directions opposite each other.

7. The magneto-optical trap apparatus according to claim 6, wherein
   the second illumination portion reflects one laser beam of the two laser beams which intersect the plane, to generate the other laser beam of the two laser beams.

8. The magneto-optical trap apparatus according to any one of claims 1 to 7, wherein
   the plane is a plane which passes through a point of symmetry of a magnetic field formed in the trap space for trapping atoms.

9. A physics package comprising:
   the magneto-optical trap apparatus according to any one of claims 1 to 8.

10. A physics package for an optical lattice clock, comprising:
    the physics package according to claim 9.

11. A physics package for an atomic clock, comprising:
    the physics package according to claim 9.

12. A physics package for an atomic interferometer, comprising:
    the physics package according to claim 9.

13. A physics package for a quantum information processing device for atoms or ionized atoms, comprising:
    the physics package according to claim 9.

14. A physics package system comprising:

    the physics package according to claim 9; and
    a control apparatus that controls an operation of the physics package.

FIG. 1

FIG. 2A

QUADRUPOLE MAGNETIC FIELD B

FIG. 2B

FIG. 3

EP 4 475 356 A1

{ a1, a2, a3, a4, a5, b }

FIG. 4

FIG. 5

EP 4 475 356 A1

FIG. 6

132A

132Ab

132Aa

132B

132Bb

132Ba

# FIG. 7

{a1,a2,a3}

{a4,a5}

150

SPLITTER

# FIG. 8

{a1,a2,a3}

160

{a4,a5}

CIRCULATOR

# FIG. 9

136C

{ a4, a5 }input

{ a1, a2, a3 } input

136B

136A

136D

136E

## FIG. 10

136C

{ a4, a5 }input

136B

132C

136D

{ a1, a2, a3 } input

136E

## FIG. 11

FIG. 12

FIG. 13

FIG. 14

## INTERNATIONAL SEARCH REPORT

| | International application No. |
|---|---|
| | **PCT/JP2023/000305** |

### A. CLASSIFICATION OF SUBJECT MATTER

**H01S 1/06**(2006.01)i; **G04F 5/14**(2006.01)i
FI: H01S1/06; G04F5/14

According to International Patent Classification (IPC) or to both national classification and IPC

### B. FIELDS SEARCHED

Minimum documentation searched (classification system followed by classification symbols)

H01S1/00-1/06; H01S3/00-4/00; H01S5/00-5/50; G04F5/14; H03L1/00-9/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

IEEE Xplore; Scitation; APS Journals

### C. DOCUMENTS CONSIDERED TO BE RELEVANT

| Category* | Citation of document, with indication, where appropriate, of the relevant passages | Relevant to claim No. |
|---|---|---|
| Y | JP 2021-163884 A (JEOL LTD) 11 October 2021 (2021-10-11)<br>paragraphs [0008], [0028]-[0050], [0060]-[0070], [0200]-[0201], fig. 1-4 | 1-14 |
| Y | JP 2006-337088 A (NATIONAL INSTITUTE OF INFORMATION & COMMUNICATIONTECHNOLOGY) 14 December 2006 (2006-12-14)<br>paragraphs [0002]-[0003], fig. 1-2 | 1-14 |
| Y | JP 2004-58225 A (INST OF PHYSICAL & CHEMICAL RES) 26 February 2004 (2004-02-26)<br>paragraphs [0045]-[0104], fig. 1-2 | 1-14 |
| Y | AKATSUKA, Tomoya et al. Three-dimensional optical lattice clock with bosonic 88Sr atoms. PHYSICAL REVIEW A. 04 February 2010, vol. 81, 023402-1 to 023402-11, DOI: 10.1103/PhysRevA.81.023402<br>fig. 1 | 1-14 |
| Y | WO 2020/141536 A1 (B.G. NEGEV TECHNOLOGIES AND APPLICATIONS LTD.) 09 July 2020 (2020-07-09)<br>p. 12, line 4 to p. 13, line 5, p. 14, line 12 to p. 15, line 25, fig. 1-2, 7 | 1-14 |

☑ Further documents are listed in the continuation of Box C. ☑ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **08 February 2023** | **28 February 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2023/000305**

### C. DOCUMENTS CONSIDERED TO BE RELEVANT

| Category* | Citation of document, with indication, where appropriate, of the relevant passages | Relevant to claim No. |
|---|---|---|
| Y | JP 6-112551 A (NIPPON TELEGR & TELEPH CORP <NTT>) 22 April 1994 (1994-04-22) paragraphs [0030]-[0035], fig. 1-3 | 2-4 |
| A | JP 2002-232041 A (COMMUNICATION RESEARCH LABORATORY) 16 August 2002 (2002-08-16) entire text, all drawings | 1-14 |
| A | JP 2021-163883 A (JEOL LTD) 11 October 2021 (2021-10-11) entire text, all drawings | 1-14 |
| A | US 2013/0048846 A1 (THE BOARD OF TRUSTEES OF THE LELAND STANFORD JUNIOR UNIVERSITY) 28 February 2013 (2013-02-28) entire text, all drawings | 1-14 |
| A | US 5274231 A (THE BOARD OF TRUSTEES OF THE LELAND STANFORD JUNIOR UNIVERSITY) 28 December 1993 (1993-12-28) entire text, all drawings | 1-14 |

Form PCT/ISA/210 (second sheet) (January 2015)

INTERNATIONAL SEARCH REPORT
Information on patent family members

International application No.

**PCT/JP2023/000305**

| Patent document cited in search report | | | Publication date (day/month/year) | Patent family member(s) | | | Publication date (day/month/year) |
|---|---|---|---|---|---|---|---|
| JP | 2021-163884 | A | 11 October 2021 | (Family: none) | | | |
| JP | 2006-337088 | A | 14 December 2006 | (Family: none) | | | |
| JP | 2004-58225 | A | 26 February 2004 | (Family: none) | | | |
| WO | 2020/141536 | A1 | 09 July 2020 | IL | 264115 | A | |
| | | | | IL | 265128 | A | |
| JP | 6-112551 | A | 22 April 1994 | (Family: none) | | | |
| JP | 2002-232041 | A | 16 August 2002 | US | 2002/0125418 | A1 | |
| | | | | EP | 1229766 | A2 | |
| JP | 2021-163883 | A | 11 October 2021 | (Family: none) | | | |
| US | 2013/0048846 | A1 | 28 February 2013 | CN | 102969038 | A | |
| US | 5274231 | A | 28 December 1993 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6206973 B
- JP 6635608 B
- JP 7189588 B
- US 11291103 B

**Non-patent literature cited in the description**

- **F. SHIMIZU**. *Optics Letters*, 1991, vol. 16, 339